# EUROPEAN PATENT APPLICATION

(11) **EP 3 916 800 A1**
(43) Date of publication of application: **01.12.2021**
(21) Application number: 21174461.0
(22) Date of filing: 18.05.2021
(51) Int. Cl.: H01L 29/40, H01L 29/66, H01L 29/78

(54) **POWER MOSFET WITH REDUCED CURRENT LEAKAGE AND METHOD OF FABRICATING THE POWER MOSFET**

(30) Priority: 27.05.2020 US 202063030642 P; 21.04.2021 US 202117236149
(71) Applicant: STMicroelectronics Pte Ltd., Singapore 569508 (SG)
(72) Inventor: YONG, Yean Ching, 550537 SINGAPORE (SG)
(74) Representative: Cabinet Beaumont

(57) **Abstract**

An integrated circuit includes a polysilicon region that is doped with a dopant. A portion of the polysilicon region is converted to a polyoxide region which includes un-oxidized dopant ions. A stack of layers overlies over the polyoxide region. The stack of layers includes: a first ozone-assisted sub-atmospheric pressure thermal chemical vapor deposition (O₃ SACVD) TEOS layer; and a second O₃ SACVD TEOS layer; wherein the first and second O₃ SACVD TEOS layers are separated from each other by a dielectric region. A thermally annealing is performed at a temperature which induces outgassing of passivation atoms from the first and second O₃ SACVD TEOS layers to migrate to passivate interface charges due to the presence of un-oxidized dopant ions in the polyoxide region.

## Description

### CROSS-REFERENCE TO RELATED APPLICATION

This application claims the priority benefit of United States Provisional Application for Patent number 63/030,642 filed on May 27, 2020, and of United States Application for Patent number 17/236,149 filed on April 21, 2021, entitled "POWER MOSFET WITH REDUCED CURRENT LEAKAGE AND METHOD OF FABRICATING THE POWER MOSFET", which are hereby incorporated by reference to the maximum extent allowable by law.

### TECHNICAL FIELD

The present invention generally relates to metal oxide semiconductor field effect transistor (MOSFET) devices and, in particular, to a power MOSFET with reduced drain current leakage.

### BACKGROUND

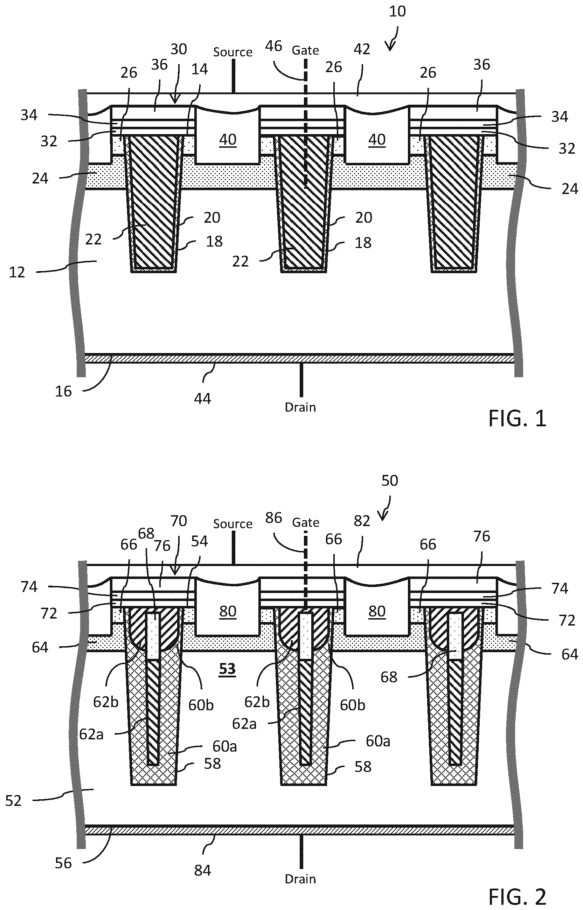

Reference is made to Figure 1 which shows a cross-section of a power metal oxide semiconductor field effect transistor (MOSFET) device 10. In this example, the MOSFET is an n-channel (nMOS) type device formed in and on a semiconductor substrate 12 doped with n-type dopant which provides the drain of the transistor 10. The substrate 12 has a front side 14 and a back side 16. A plurality of trenches 18 extend depthwise into the substrate 12 from the front side 14. The trenches 18 extend lengthwise parallel to each other in a direction perpendicular to the cross-section (i.e., into and out the page of the illustration) and form strips (this type of transistor device commonly referred to in the art as a strip-FET type transistor).

A region 24 doped with a p-type dopant is buried in the substrate 12 at a depth offset from (i.e., below) the front side 14 and positioned extending parallel to the front side 14 on opposite sides of each trench 18. The doped region 24 forms the body (channel) region of the transistor, with the trench 18 passing completely through the doped body region 24 and into the substrate 12 below the doped body region 24. A region 26 heavily doped with an n-type dopant is provided at the front side 14 of the substrate 12 and positioned extending parallel to the front side 14 on opposite sides of each trench 18 and in contact with the top of the doped body region 24. The doped region 26 forms the source of the transistor, with the trench 18 passing completely through the doped source region 26 and further extending, as noted above, completely through the doped body region 24 into the substrate 12 below the doped body region 24.

The side walls and bottom of each trench 18 are lined with an insulating layer 20. For example, the insulating layer 20 may comprise an oxide layer (which, in an embodiment, is thermally grown from the exposed surfaces of the substrate 12 in each trench 18). Each trench 18 is filled by a polysilicon material 22, with the insulating layer 20 insulating the polysilicon material 22 from the substrate 12. The polysilicon material 22 forms the gate of the transistor 10 and the insulating layer 20 is the gate oxide layer.

A stack 30 of layers is formed over each trench 18 and laterally extends on opposite sides of each trench 18 over at least a portion of the doped regions 26 for the source. Each stack 30 comprises a nitride layer 32, and a dielectric region formed by an undoped oxide (for example, tetraethyl orthosilicate (TEOS)) layer 34 and a glass (for example, borophosphosilicate glass (BPSG)) layer 36.

A source metal contact 40 extends through the stack 30 at a position between adjacent trenches 18 to make electrical contact with the doped source regions 26. Each source metal contact 40 extends depthwise into the substrate to pass through the doped source region 26 and into the doped body region 24 (thus providing a body contact for the transistor 10 that is tied to the source). A source metal layer 42 extends over both the stack 30 and the source metal contacts 40 to provide a metal connection to and between all the source metal contacts 40. The stack 30 of layers insulates both the source metal layer 42 and the source metal contacts 40 from the gate (polysilicon region 22). A drain metal layer 44 extends over the back side 16 of the substrate 12 to provide a metal connection to the drain. A gate metal layer (not explicitly shown as it is offset in a direction perpendicular to the cross-section) makes an electrical connection to the gate (polysilicon region 22) in each trench 18, this gate metal layer and electrical connection being schematically shown by dotted line 46.

The transistor 10 could instead be a pMOS type transistor where the substrate 12 and doped source region 16 are both p-type doped and the body region 14 is n-type doped.

Reference is now made to Figure 2 which shows a cross-section of a power metal oxide semiconductor field effect transistor (MOSFET) device 50. In this example, the MOSFET is an n-channel (nMOS) type device formed in and on a semiconductor substrate 52 doped with n-type dopant which provides the drain of the transistor 50. The substrate 52 has a front side 54 and a back side 56. A plurality of trenches 58 extend depthwise into the substrate 52 from the front side 54. The trenches 58 extend lengthwise parallel to each other in a direction perpendicular to the cross-section (i.e., into and out the page of the illustration) and form strips (this type of transistor device commonly referred to in the art as a strip-FET type transistor).

A region 64 doped with a p-type dopant is buried in the substrate 52 at a depth offset from (i.e., below) the front side 54 and positioned extending parallel to the front side 54 on opposite sides of each trench 58. The doped region 64 forms the body (channel) region of the transistor, with the trench 58 passing completely through the doped body region 64 and into the substrate 52 below the doped body region 64. A region 66 doped with an n-type dopant is provided at the front side 54 of the substrate 52 and positioned extending parallel to the front side 54 on opposite sides of each trench 58 and in contact with the top of the doped body region 64. The doped region 66 forms the source of the transistor, with the trench 58 passing completely through the doped source region 66 and further extending, as noted above, completely through the doped body region 64 into the substrate 52 below the doped body region 64.

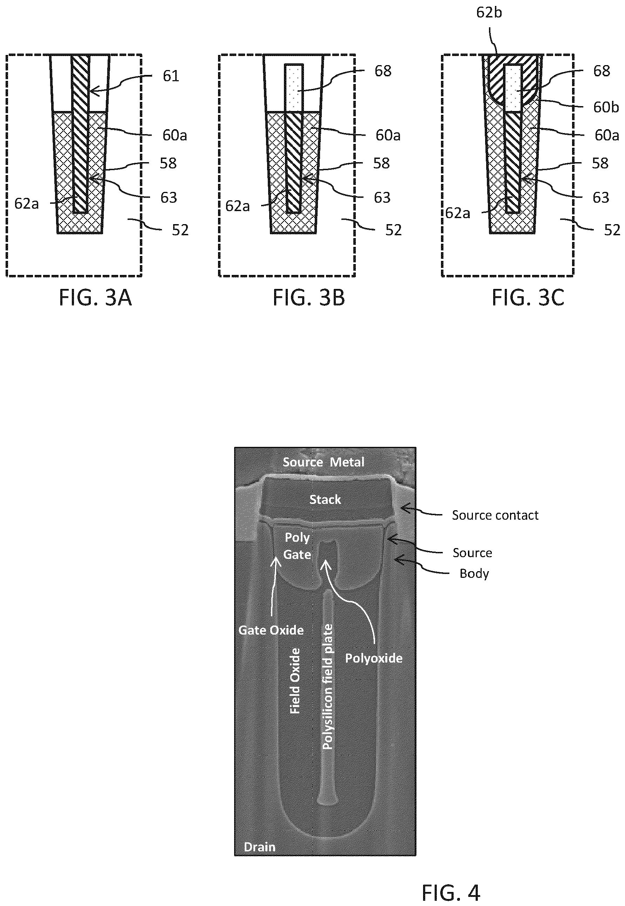

The side walls and bottom of each trench 58 are lined with a first insulating layer 60a. For example, the insulating layer 60a may comprise a thick oxide layer. The trench 58 is then filled by a first polysilicon material 62a, with the insulating layer 60a insulating the first polysilicon material 62a from the substrate 52. The polysilicon material 62a is a heavily n-type doped polysilicon material (for example, Phosphorus doped with a doping concentration of 5 x 10²⁰ at/cm³). During the process for fabricating the transistor 50, an upper portion of the insulating layer 60a (which would be adjacent to both the doped body region 64 and doped region 66) is removed from the trench 58 to expose a corresponding upper portion 61 of the polysilicon material 62a (see, Figure 3A). This exposed upper portion 61 of the polysilicon material 62a is then converted (for example, using a thermal oxidation process) to form a polyoxide region 68 that is vertically aligned in the trench 58 with the remaining (lower) portion 63 of the polysilicon material 62a (See, Figure 3B). This remaining lower portion 63 of the polysilicon material 62a forms a field plate electrode (also referred to as a polysource region) of the transistor 50. The side walls and bottom of the upper portion of each trench 58 are then lined with a second insulating layer 60b (see, Figure 3C). For example, the insulating layer 60b may comprise a thermally grown oxide layer. The upper portion of each trench 58 is then filled by a second polysilicon material 62b, with the insulating layer 60b insulating the second polysilicon material 62b from the substrate 52 (including regions 64 and 66). The second polysilicon material 62b forms the gate of the transistor 50 which includes two portions extending on opposite sides of the polyoxide region 68 and a further part which electrically couples those two portions and extends over the polyoxide region 68. The insulating layer 60b forms the gate oxide layer.

A stack 70 of layers is formed over the substrate 52 and laterally extends on opposite sides of each trench 58 over at least a portion of the doped regions 66 for the source. Each stack 70 comprises a nitride layer 72, a dielectric region formed by an undoped oxide (for example, tetraethyl orthosilicate (TEOS)) layer 74 and a glass (for example, borophosphosilicate glass (BPSG)) layer 76.

A source metal contact 80 extends through the stack 70 to make electrical contact with each doped source region 66. Each source metal contact 80 extends depthwise into the substrate to pass through the doped source region 66 and into the doped body region 64 (thus providing a body contact for the transistor 50 that is tied to the source). A source metal layer 82 extends over the stack 70 and source metal contacts 80 to provide a metal connection to and between all the source metal contacts 80, with the stack 70 insulating both source metal layer 82 and the source metal contacts 80 from the gate (second polysilicon region 62b). A drain metal layer 84 extends over the back side 56 of the substrate 52 to provide a metal connection to the drain. A gate metal layer (not shown as it is offset in a direction perpendicular to the cross-section) makes an electrical connection to the gate (second polysilicon region 62b) in each trench, this gate metal layer and electrical connection being schematically shown by dotted line 86. A field electrical connection (not explicitly shown) is provided between the source and the remaining lower portion of the polysilicon material 62a which forms the field plate (polysource region) electrode that is electrically insulated from the gate.

The transistor 50 could instead be a pMOS type transistor where the polysilicon material 62a is a heavily p-type doped polysilicon material, the substrate 52 and doped source region 56 are both p-type doped and the body region 54 is n-type doped.

A scanning electron micrograph (SEM) cross-sectional image of a single cell of the transistor 50 is shown in Figure 4.

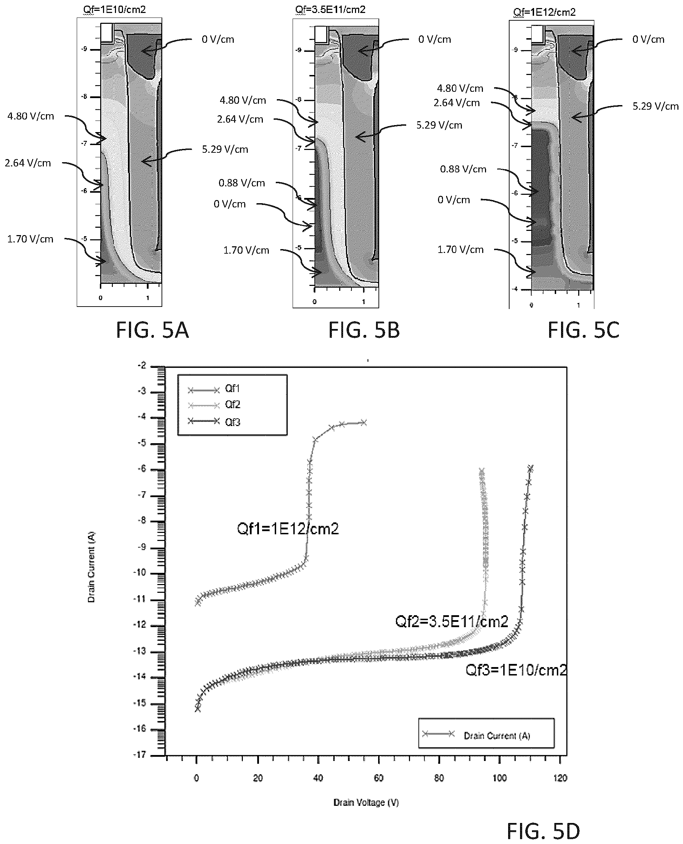

Because the polyoxide region 68 is thermally grown from the heavily n-type doped polysilicon material 62a, this oxide will be heavily doped with the n-type dopants used to dope the polysilicon material 62a. For example, in the implementation described above, the oxide would be heavily doped with Phosphorus atoms, and the polyoxide region 68 can then include un-oxidized (or oxygen deficient) Phosphorus ions. These ions act as a sink for Oxygen atoms that are released from the Silicon-Silicon Oxide interface (which is located at the edge of each trench where the insulating layer 60a is in contact with the substrate 52) during transistor fabrication processes that use high temperatures. As a result, there is an unacceptable increase in the interface charge density. This is disadvantageous because the density of interface charge is critical for controlling IDSS (i.e., drain current at a near body-drain breakdown voltage with source-gate shorted) current leakage level. The density of interface charge disrupts the electric field in the mesa region 53 of the transistor 50 structure, this mesa region including at least the portion of the substrate 52 and the portion of the doped region 64 that is located between adjacent trenches. This disruption is shown by the simulation of interface charge density to electric field in Figures 5A-5D. Figure 5D shows drain leakage for different interface charge density from Qf: 1 x 10¹⁰ cm⁻²; Qf: 3.5 x 10¹¹ cm⁻²; Qf: 1 x 10¹² cm⁻², while the electric field distribution for these interface charge densities are shown in Figures 5A, 5B and 5C, respectively. Figures 5A-5C show that electric field is disrupted when interface charge are increased above 1 x 10¹⁰ and the corresponding drain leakage current increases. The simulation here is performed with a TCAD software by sweeping drain voltage from 0 to 120V; keeping the gate and source grounded.

There is accordingly a need in the art to address concerns with IDSS current leakage in power MOSFET devices.

### SUMMARY

In an embodiment, an integrated circuit MOSFET device comprises: a substrate providing a drain; a first doped region buried in the substrate providing a body; a second doped region in the substrate providing a source, wherein the second doped region is adjacent the first doped region; a trench extending into the substrate and passing through first and second doped regions; a polyoxide region within the trench; a first conductive region within the trench providing a gate, wherein the first conductive region is adjacent to the polyoxide region; and a stack of layers extending over the first conductive region and polyoxide region within the trench. The stack of layers includes: a first ozone-assisted sub-atmospheric pressure thermal chemical vapor deposition (O₃ SACVD) TetraEthylOrthoSilicate (TEOS) layer; and a second O₃ SACVD TEOS layer; wherein the first and second O₃ SACVD TEOS layers are separated from each other by a dielectric region.

In an embodiment, the first O₃ SACVD TEOS layer is positioned within the stack of layers adjacent a top of the trench and the stack of layers further includes a nitride layer in contact with the first O₃ SACVD TEOS layer.

In an embodiment, the second O₃ SACVD TEOS layer is positioned within the stack of layers separated from the top of the trench by the dielectric region and the dielectric region includes a BoroPhosphoSilicate Glass (BPSG) layer in contact with the second O₃ SACVD TEOS layer.

In an embodiment, the stack of layers comprises, stacked in order from and over a top of the trench:
the first O₃ SACVD TEOS layer;
a nitride layer in contact with the first O₃ SACVD TEOS layer;
an undoped oxide layer in contact with the nitride layer;
a BPSG layer in contact with the undoped oxide layer; and
the second O₃ SACVD TEOS layer in contact with the BPSG layer.

In an embodiment, the polyoxide region includes dopant ions and the first and second O₃ SACVD TEOS layers provide a source of Hydrogen for passivating interface charges due to the presence of the dopant ions in the polyoxide region.

In an embodiment, the first conductive region is made of a polysilicon material.

In an embodiment, the trench further includes a second conductive region which is electrically insulated from the first conductive region, the second conductive region being for instance made of a polysilicon material.

In an embodiment, the second conductive region is made of a polysilicon material and the polyoxide region is formed from an oxidized portion of the second conductive region polysilicon material, the polysilicon material of the second conductive region being for instance doped with Phosphorus, and the oxidized portion of the second conductive region forming the polyoxide region for instance including un-oxidized Phosphorus ions.

In an embodiment, the first and second O₃ SACVD TEOS layers provide a source of Hydrogen for passivating interface charges due to the presence of the un-oxidized Phosphorus ions in the polyoxide region.

In an embodiment, a method of making an integrated circuit device comprises: forming a trench in a substrate which includes a first polysilicon material doped with a dopant; oxidizing a portion of the first polysilicon material to form a polyoxide region within the trench, said polyoxide region including un-oxidized dopant ions; producing a stack of layers extending over the trench, wherein the stack includes: a first ozone-assisted sub-atmospheric pressure thermal chemical vapor deposition (O₃ SACVD) TEOS layer; and a second O₃ SACVD TEOS layer; wherein the first and second O₃ SACVD TEOS layers are separated from each other by a dielectric region; performing a thermal anneal at a temperature which induces outgassing of passivation atoms from the first and second O₃ SACVD TEOS layers to migrate to passivate interface charges due to the presence of un-oxidized dopant ions in the polyoxide region.

In an embodiment, the passivation atoms are Hydrogen atoms.

In an embodiment, the un-oxidized dopant ions are Phosphorus ions.

In an embodiment, producing the stack of layers comprises:
depositing the first O₃ SACVD TEOS layer over the trench;
depositing a nitride layer in contact with the first O₃ SACVD TEOS layer;
depositing an undoped oxide layer in contact with the nitride layer;
depositing a BPSG layer in contact with the undoped oxide layer; and
depositing the second O₃ SACVD TEOS layer in contact with the BPSG layer.

In an embodiment, performing the thermal anneal comprises thermally annealing at the temperature in dry Nitrogen.

In an embodiment, performing the thermal anneal comprises thermally annealing at the temperature in wet plus dry Nitrogen.

In an embodiment, the temperature is in excess of 900°C.

In an embodiment, a method of making an integrated circuit comprises: forming a polysilicon region that is doped with a dopant; converting a portion of the polysilicon region to a polyoxide region which includes un-oxidized dopant ions; applying a stack of layers over the polyoxide region, wherein the stack of layers includes: a first ozone-assisted sub-atmospheric pressure thermal chemical vapor deposition (O₃ SACVD) TEOS layer; and a second O₃ SACVD TEOS layer; wherein the first and second O₃ SACVD TEOS layers are separated from each other by a dielectric region; thermally annealing at a temperature which induces outgassing of passivation atoms from the first and second O₃ SACVD TEOS layers to migrate to passivate interface charges due to the presence of un-oxidized dopant ions in the polyoxide region.

In an embodiment, the passivation atoms are Hydrogen atoms.

In an embodiment, the un-oxidized dopant ions are Phosphorus ions.

In an embodiment, performing the thermal anneal comprises thermally annealing at the temperature in dry Nitrogen.

In an embodiment, performing the thermal anneal comprises thermally annealing at the temperature in wet plus dry Nitrogen.

In an embodiment, the temperature is in excess of 900°C.

In an embodiment, an integrated circuit comprises: a substrate including a polyoxide region; and a stack of layers extending over the polyoxide region in the substrate, wherein the stack of layers includes: a first ozone-assisted sub-atmospheric pressure thermal chemical vapor deposition (O₃ SACVD) TEOS layer; and a second O₃ SACVD TEOS layer; wherein the first and second O₃ SACVD TEOS layers are separated from each other by a dielectric region.

In an embodiment, the first O₃ SACVD TEOS layer is positioned within the stack of layers adjacent a top of the substrate and the stack of layers further includes a nitride layer in contact with the first O₃ SACVD TEOS layer.

In an embodiment, the second O₃ SACVD TEOS layer is positioned within the stack of layers separated from the top of the substrate by the dielectric region and the dielectric region includes a BPSG layer in contact with the second O₃ SACVD TEOS layer.

In an embodiment, the stack of layers comprises, in order from a top of the substrate:
the first O₃ SACVD TEOS layer;
a nitride layer in contact with the first O₃ SACVD TEOS layer;
an undoped oxide layer in contact with the nitride layer;
a BPSG layer in contact with the undoped oxide layer; and
the second O₃ SACVD TEOS layer in contact with the BPSG layer.

In an embodiment, the polyoxide region includes dopant ions and the first and second O₃ SACVD TEOS layers provide a source of Hydrogen for passivating interface charges due to the presence of the dopant ions in the polyoxide region.

In an embodiment, the polyoxide region is formed from an oxidized portion of a polysilicon region within the substrate, the polysilicon region being for instance doped with Phosphorus, and the oxidized portion for instance including un-oxidized Phosphorus ions.

In an embodiment, the oxidized portion includes un-oxidized Phosphorus ions and the first and second O₃ SACVD TEOS layers provide a source of Hydrogen for passivating interface charges due to the presence of the un-oxidized Phosphorus ions in the polyoxide region.

In an embodiment, the substrate includes a trench within which the polyoxide region is located.

In an embodiment, the trench further includes a conductive region adjacent the polyoxide region, said conductive region forming a gate of a transistor.

### BRIEF DESCRIPTION OF THE DRAWINGS

For a better understanding of the embodiments, reference will now be made by way of example only to the accompanying figures in which:
Figure 1 is a cross-section of a power metal oxide semiconductor field effect transistor (MOSFET) device;
Figure 2 is a cross-section of a power MOSFET device;
Figures 3A-3C show process steps in the manufacture of the power MOSFET device of Figure 2;
Figure 4 is a scanning electron micrograph image of a cross-section of the power MOSFET device of Figure 2;
Figures 5A-5D illustrate results of a simulation of interface charge density to electric field distribution for the power MOSFET device of Figure 2;
Figure 6 is a cross-section of a power MOSFET device;
Figure 7 is a scanning electron micrograph image of a cross-section of the power MOSFET device of Figure 6;
Figure 8 is a flow diagram showing process steps for the fabrication of the stack of layers; and
Figure 9 is a graph showing drain current I_{DSS} as a function of breakdown voltage BV for the transistor of Figure 2 and the transistor of Figure 6.

### DETAILED DESCRIPTION

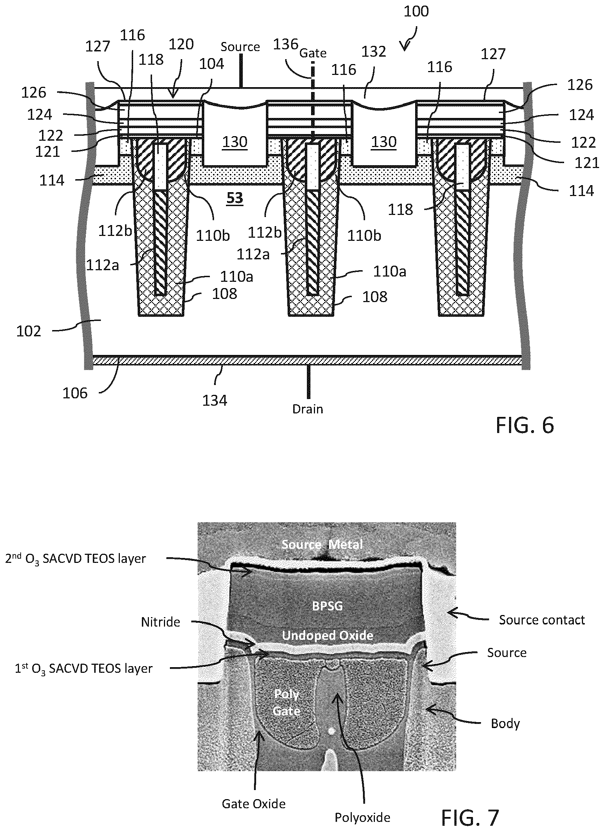

Reference is now made to Figure 6 which shows a cross-section of a power metal oxide semiconductor field effect transistor (MOSFET) device 100. In this example, the MOSFET is an n-channel (nMOS) type device formed in and on a semiconductor substrate 102 doped with n-type dopant which provides the drain of the transistor 100. The substrate 102 has a front side 104 and a back side 106. A plurality of trenches 108 extend depthwise into the substrate 102 from the front side 104. The trenches 108 extend lengthwise parallel to each other in a direction perpendicular to the cross-section (i.e., into and out the page of the illustration) and form strips (this type of transistor device commonly referred to in the art as a strip-FET type transistor).

A region 114 doped with a p-type dopant is buried in the substrate 102 at a depth offset from (i.e., below) the front side 104 and positioned extending parallel to the front side 104 on the opposite sides of each trench 108. The doped region 114 forms the body (channel) region of the transistor, with the trench 108 passing completely through the doped body region 114 and into the substrate 102 below the doped body region 114. A region 116 doped with an n-type dopant is provided at the front side 104 of the substrate 102 and positioned extending parallel to the front side 104 on opposite sides of each trench 108 and in contact with the top of the doped body region 114. The doped region 116 forms the source of the transistor, with the trench 108 passing completely through the doped source region 116 and further extending, as noted above, completely through the doped body region 114 into the substrate 102 below the doped body region 114.

The side walls and bottom of each trench 108 are lined with a first insulating layer 110a. For example, the insulating layer 110a may comprise a thick oxide layer. The trench 108 is then filled by a first polysilicon material 112a, with the insulating layer 110a insulating the first polysilicon material 112a from the substrate 102. The polysilicon material 112a is a heavily n-type doped polysilicon material (for example, Phosphorus doped with a doping concentration of 5 x 10²⁰ at/cm³). During the process for fabricating the transistor 100 (see, for example, Figures 3A-3C), an upper portion of the insulating layer 110a (which would be adjacent to both the doped body region 114 and doped source region 116) is removed from the trench 108 to expose a corresponding upper portion of the polysilicon material 112a. This exposed upper portion of the polysilicon material 112a is then converted (for example, using a thermal oxidation process) to form a polyoxide region 118 that is vertically aligned in the trench 108 with the remaining (lower) portion of the polysilicon material 112a. This remaining lower portion of the polysilicon material 112a forms a field plate (polysource region) electrode of the transistor 100. The side walls and bottom of the upper portion of each trench 108 are then lined with a second insulating layer 110b. For example, the insulating layer 110b may comprise a thermally grown oxide layer. The upper portion of each trench 108 is then filled by a second polysilicon material 112b, with the insulating layer 110b insulating the second polysilicon material 112b from the substrate 102 (including regions 114 and 116). The second polysilicon material 112b forms the gate of the transistor 100 which includes first and second portions extending on opposite sides of the polyoxide region 118 and a further part electrically coupling the first and second portions and extending over the poly oxide region 118. The insulating layer 110b forms the gate oxide layer.

A stack 120 of layers is formed over the substrate and laterally extends on opposite sides of each trench 108 over at least a portion of the doped regions 116 for the source. The layers of the stack 120 include: a first ozone-assisted sub-atmospheric pressure thermal chemical vapor deposition (O₃ SACVD) TEOS layer 121, a nitride layer 122, an undoped oxide (for example, TEOS) layer 124, a glass (for example, BPSG) layer 126 and a second O₃ SACVD TEOS layer 127. The undoped oxide layer 124 and a glass layer 126 form a dielectric region of the stack 120. The first and second O₃ SACVD layers 121 and 127 are thin layers each having thicknesses on the order of 10-100,000 Angstroms. In an embodiment, the first O₃ SACVD layer 121 may have a thickness of about 200 Angstroms and the second O₃ SACVD layer 127 may have a thickness of about 3000 Angstroms. For comparison purposes, the nitride layer 122 may, for example, have a thickness on the order of about 700 Angstroms, the undoped oxide layer 124 may have a thickness of about 2000 Angstroms, and the glass layer 126 may have a thickness of about 5000 Angstroms.

A source metal contact 130 extends through the layers of the stack 120 at positions for making electrical contact with the doped source regions 116. Each source metal contact 130 extends depthwise into the substrate to pass through the doped source region 116 and into the doped body region 114 (thus providing a body contact for the transistor 100 that is tied to the source). A source metal layer 132 extends over the stacks 120 and source metal contacts 130 to provide a metal connection to and between all the source metal contacts 130, with the stack 120 of layer insulating both source metal layer 132 and the source metal contacts 130 from the gate (second polysilicon region 112b). A drain metal layer 134 extends over the back side 106 of the substrate 102 to provide a metal connection to the drain. A gate metal layer (not shown as it is offset in a direction perpendicular to the cross-section) makes an electrical connection to the gate (second polysilicon region 112b) in each trench, this gate metal layer and electrical connection being schematically shown by dotted line 136. A field electrical connection (not explicitly shown) is provided between the source and the remaining lower portion of the polysilicon material 112a which forms the field plate (polysource region) electrode.

A scanning electron micrograph (SEM) cross-sectional image of a single cell of the transistor 100, focusing on the area of the gate and stack, is shown in Figure 7.

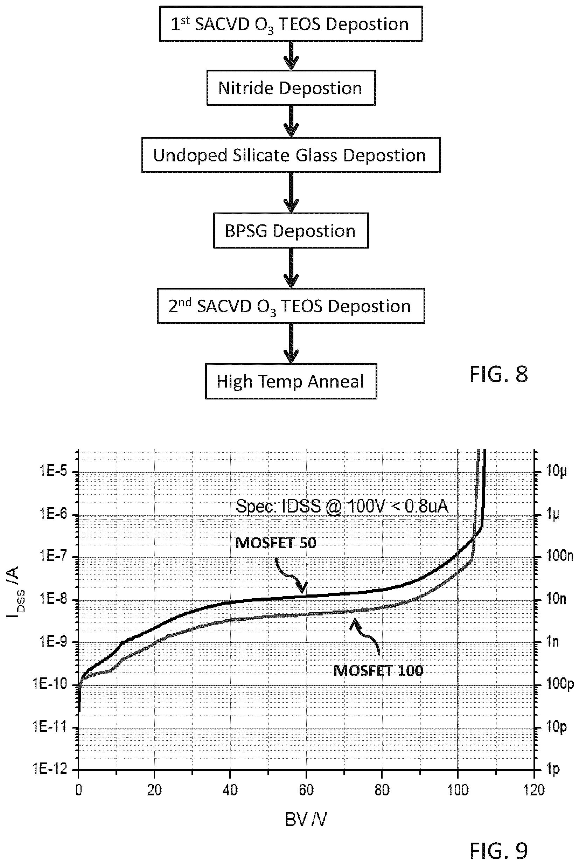

Figure 8 is a flow diagram showing process steps for the fabrication of the stack 120 of layers. A first TEOS layer 121 is deposited using ozone-assisted sub-atmospheric pressure thermal chemical vapor deposition (O₃ SACVD) on top of the substrate 102 over the location of each filled trench 108. Next, the nitride layer 122 is deposited on top of the first TEOS layer 121. Then, an undoped silicate glass oxide layer 124 is deposited on top of the nitride layer 122. A BPSG layer 126 is then deposited on top of the undoped silicate glass oxide layer 124. Then, a second TEOS layer 121 is deposited using ozone-assisted sub-atmospheric pressure thermal chemical vapor deposition (O₃ SACVD) on top of the BPSG layer 126. A thermal annealing is then performed in dry Nitrogen (N₂) or wet plus dry Nitrogen (N₂) at an ambient annealing (high) temperature in excess of 900°C (for example, at a temperature of about 940°C). The first and second O₃ SACVD layers 121 and 127 each serve as a source of Hydrogen atoms which are outgassed during the thermal anneal. In response to the processing at the ambient annealing temperature, these outgassed Hydrogen atoms diffuse from the stack 120 towards the substrate to passivate interface charges due to the presence of un-oxidized dopant atom ions (for example, Phosphorus ions in the example embodiment) in the polyoxide region 118 within the trench 108. This passivation, in combination with the annealing being performed in the presence of Nitrogen, serves to reduce interface charge. Although an annealing temperature in excess of 900°C is preferred, it will be understood that what is required of the annealing temperature is that it be sufficient to produce the outgassing of Nitrogen and further that it be higher than any process temperature that subsequently used in the fabrication of the transistor.

It will be noted that O₃ TEOS as used in layers 121 and 127 belongs to a silanol group which belongs to the functional group in silicon chemistry with the connectivity of Si-O-H. When subjected to a high temperature anneal, the phenomena of desorption of water and Hydrogen occurs providing for an outgassing of Hydrogen atoms. See, Li, et al., "Hydrogen outgassing induced liner/barrier reliability degradation in through silicon via's", Appl. Phys. Lett. 104, 142906 (2014); and Hirashita, et al., "Thermal Desorption and Infrared Studies of Plasma-Enhanced Chemical Vapor Deposited SiO Films with Tetraethylorthosilicate", Japanese Journal of Applied Physics, Volume 32, Part 1, Number 4 (1993). This outgassed Hydrogen is advantageously used for the transistor 100 in the passivation of the interface charges due to the presence of the Phosphorus ions.

Reference is now made to Figure 9 which is a graph showing drain current I_{DSS} as a function of breakdown voltage BV for the transistor 50 of Figure 2 and the transistor 100 of Figure 6. For a specification requirement, for example, of I_{DSS} less than 0.8 µA at BV=100V, it will be noted that the transistor 50 of Figure 2 will provide an I_{DSS} ~ 0.1 µA. The transistor 100 of Figure 6, however, will provide an I_{DSS} ~ 40nA, and thus transistor 100 has a 2.5 times reduction in leakage level compared to the transistor 50.

It will also be noted that the presence of both the first and second O₃ SACVD layers 121 and 127 in the stack 120 is needed in order to achieve the beneficial reduction in leakage level as shown in Figure 9. Experimentation has shown that the presence of only one of the two O₃ SACVD layers 121 and 127 alone will not produce a substantive improvement in leakage level compared to the transistor 50 of Figure 2. The use of both O₃ SACVD layers 121 and 127 along with the thermal annealing in dry Nitrogen (N₂) or wet plus dry Nitrogen (N₂) at a high ambient annealing temperature (for example, about 940°C) causes an outgassing of Hydrogen from the layers 121 and 127 which helps to passivate interface charges in the Si/SiO₂ interface creased by the high Phosphorus ion concentration in the polyoxide region 118.

Although the example of Figure 6 is for an nMOS transistor, it will be understood that the disclosed implementation is equally applicable to a pMOS transistor (i.e., where the polysilicon material 112a is a heavily p-type doped polysilicon material, the substrate 102 and doped source region 116 are both p-type doped and the body region 114 is n-type doped.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. An integrated circuit MOSFET device (100), comprising:
a substrate (102) providing a drain;
a first doped region (114) buried in the substrate providing a body;
a second doped region (116) in the substrate providing a source, wherein the second doped region is adjacent the first doped region;
a trench (108) extending into the substrate (102) and passing through first and second doped regions;
a polyoxide region (118) within the trench;
a first conductive region within the trench providing a gate, wherein the first conductive region is adjacent to the polyoxide region;
a stack (120) of layers extending over the first conductive region and polyoxide region (118) within the trench (108), wherein the stack of layers includes:
a first ozone-assisted sub-atmospheric pressure thermal chemical vapor deposition (O₃ SACVD) TetraEthylOrthoSilicate (TEOS) layer (121); and
a second O₃ SACVD TEOS layer (127);
wherein the first and second O₃ SACVD TEOS layers are separated from each other by a dielectric region.

2. The integrated circuit MOSFET device (100) of claim 1, wherein the first O₃ SACVD TEOS layer (121) is positioned within the stack (120) of layers adjacent a top of the trench (108) and wherein the stack of layers further includes a nitride layer (122) in contact with the first O₃ SACVD TEOS layer, and/or wherein the second O₃ SACVD TEOS layer (127) is positioned within the stack (120) of layers separated from the top of the trench (108) by the dielectric region and wherein the dielectric region includes a BoroPhosphoSilicate Glass (BPSG) layer (126) in contact with the second O₃ SACVD TEOS layer.

3. The integrated circuit MOSFET device (100) of claim 1 or 2, wherein the stack (120) of layers comprises, stacked in order from and over a top of the trench (108):
the first O₃ SACVD TEOS layer (121);
a nitride layer (122) in contact with the first O₃ SACVD TEOS layer;
an undoped oxide layer (124) in contact with the nitride layer;
a BPSG layer (126) in contact with the undoped oxide layer; and
the second O₃ SACVD TEOS layer (127) in contact with the BPSG layer.

4. The integrated circuit MOSFET device of any of claims 1 to 3, wherein the first conductive region is made of a polysilicon material.

5. The integrated circuit MOSFET device (100) of any of claims 1 to 4, wherein the trench (108) further includes a second conductive region which is electrically insulated from the first conductive region, the second conductive region being for instance made of a polysilicon material (112a).

6. The integrated circuit MOSFET device (100) of claim 5, wherein the second conductive region is made of a polysilicon material (112a) and the polyoxide region (118) is formed from an oxidized portion of the second conductive region polysilicon material (112a), the polysilicon material (112a) of the second conductive region being for instance doped with Phosphorus, and the oxidized portion of the second conductive region forming the polyoxide region (118) for instance including un-oxidized Phosphorus ions.

7. A method of making an integrated circuit device (100), comprising:
forming a trench (108) in a substrate (102) which includes a first polysilicon material (112a) doped with a dopant;
oxidizing a portion of the first polysilicon material to form a polyoxide region (118) within the trench, said polyoxide region including un-oxidized dopant ions;
producing a stack (120) of layers extending over the trench, wherein the stack includes:
a first ozone-assisted sub-atmospheric pressure thermal chemical vapor deposition (O₃ SACVD) TEOS layer (121); and
a second O₃ SACVD TEOS layer (127);
wherein the first and second O₃ SACVD TEOS layers are separated from each other by a dielectric region;
performing a thermal anneal at a temperature which induces outgassing of passivation atoms from the first and second O₃ SACVD TEOS layers to migrate to passivate interface charges due to the presence of un-oxidized dopant ions in the polyoxide region (118).

8. The method of claim 7, wherein producing the stack (120) of layers comprises:
depositing the first O₃ SACVD TEOS layer (121) over the trench (108);
depositing a nitride layer (122) in contact with the first O₃ SACVD TEOS layer;
depositing an undoped oxide layer (124) in contact with the nitride layer;
depositing a BPSG layer (126) in contact with the undoped oxide layer; and
depositing the second O₃ SACVD TEOS layer in contact with the BPSG layer.

9. A method of making an integrated circuit, comprising:
forming a polysilicon region that is doped with a dopant;
converting a portion of the polysilicon region to a polyoxide region (118) which includes un-oxidized dopant ions;
applying a stack (120) of layers over the polyoxide region, wherein the stack of layers includes:
a first ozone-assisted sub-atmospheric pressure thermal chemical vapor deposition (O₃ SACVD) TEOS layer (121); and
a second O₃ SACVD TEOS layer (127);
wherein the first and second O₃ SACVD TEOS layers are separated from each other by a dielectric region;
thermally annealing at a temperature which induces outgassing of passivation atoms from the first and second O₃ SACVD TEOS layers to migrate to passivate interface charges due to the presence of un-oxidized dopant ions in the polyoxide region.

10. The method of claim 7 or 8 or the method of claim 9, wherein the passivation atoms are Hydrogen atoms, and/or wherein the un-oxidized dopant ions are Phosphorus ions.

11. The method of any of claims 7, 8, 10 or the method of claim 9 or 10, wherein performing the thermal anneal comprises thermally annealing at the temperature in dry Nitrogen, or in wet plus dry Nitrogen, the temperature being for instance is in excess of 900°C.

12. An integrated circuit, comprising:
a substrate (102) including a polyoxide region (118); and
a stack (120) of layers extending over the polyoxide region in the substrate, wherein the stack of layers includes:
a first ozone-assisted sub-atmospheric pressure thermal chemical vapor deposition (O₃ SACVD) TEOS layer (121); and
a second O₃ SACVD TEOS layer (127);
wherein the first and second O₃ SACVD TEOS layers are separated from each other by a dielectric region.

13. The integrated circuit of claim 12, wherein the first O₃ SACVD TEOS layer (121) is positioned within the stack (120) of layers adjacent a top of the substrate (102) and wherein the stack of layers further includes a nitride layer (122) in contact with the first O₃ SACVD TEOS layer, and/or wherein the second O₃ SACVD TEOS layer (127) is positioned within the stack (120) of layers separated from the top of the substrate (102) by the dielectric region and wherein the dielectric region includes a BPSG layer (126) in contact with the second O₃ SACVD TEOS layer.

14. The integrated circuit of claim 12 or 13, wherein the stack (120) of layers comprises, in order from a top of the substrate (102):
the first O₃ SACVD TEOS layer (121);
a nitride layer (122) in contact with the first O₃ SACVD TEOS layer;
an undoped oxide layer (124) in contact with the nitride layer;
a BPSG layer (126) in contact with the undoped oxide layer; and
the second O₃ SACVD TEOS layer (127) in contact with the BPSG layer.

15. The integrated circuit MOSFET device (100) of any of claims 1 to 6 or the integrated circuit of any of claims 12 to 14, wherein the polyoxide region (118) includes dopant ions and wherein the first and second O₃ SACVD TEOS layers provide a source of Hydrogen for passivating interface charges due to the presence of the dopant ions in the polyoxide region.

16. The integrated circuit of any of claims 12 to 15, wherein the polyoxide region (118) is formed from an oxidized portion of a polysilicon region within the substrate (102), the polysilicon region (118) being for instance doped with Phosphorus, and the oxidized portion for instance including un-oxidized Phosphorus ions.

17. The integrated circuit MOSFET device (100) of claim 6 or the integrated circuit of claim 16, wherein the oxidized portion includes un-oxidized Phosphorus ions and wherein the first and second O₃ SACVD TEOS layers provide a source of Hydrogen for passivating interface charges due to the presence of the un-oxidized Phosphorus ions in the polyoxide region.

18. The integrated circuit of any of claims 12 to 17, wherein the substrate (102) includes a trench (108) within which the polyoxide region (118) is located, the trench (108) further including for instance a conductive region adjacent the polyoxide region (118), said conductive region forming a gate of a transistor.
